# FASCICULE DE BREVET EUROPEEN

(11) **EP 3 847 693 B1**
(45) Date de publication et mention de la délivrance du brevet: **24.04.2024**
(21) Numéro de dépôt: 19774171.3
(22) Date de dépôt: 03.09.2019
(51) Int. Cl.: H01L 27/12, H01L 21/762, H01L 21/84

(54) **PROCEDE DE FABRICATION D'UN DISPOSITIF CFET**
VERFAHREN ZUR HERSTELLUNG EINER CFET-VORRICHTUNG
METHOD FOR MANUFACTURING A CFET DEVICE

(30) Priorité: 03.09.2018 FR 1857894
(43) Date de publication de la demande: 14.07.2021
(73) Titulaire: SOITEC, 38190 Bernin (FR)
(72) Inventeur: SCHWARZENBACH, Walter, 38330 Saint Nazaire les Eymes (FR); ECARNOT, Ludovic, 38000 Grenoble (FR); DAVAL, Nicolas, 38570 Goncelin (FR); NGUYEN, Bich-Yen, Austin, TX 78733 (US); BESNARD, Guillaume, 35690 Acigné (FR)
(74) Mandataire: Regimbeau
(86) Numéro de dépôt international: PCT/FR2019/052026
(87) Numéro de publication internationale: WO 2020/049251

(56) Documents cités:
- EP-A1- 1 158 581
- WO-A1-2010/106101
- WO-A1-2017/095409
- FR-A1- 2 895 563
- US-A1- 2006 289 940
- US-A1- 2007 181 947
- US-B1- 9 812 575
- CHAN M ET AL: "Stacked 3-D Fin-CMOS Technology", IEEE ELECTRON DEVICE LETTERS, IEEE SERVICE CENTER, NEW YORK, NY, US, vol. 26, no. 6, 1 juin 2005 (2005-06-01), pages 416-418, XP011132416, ISSN: 0741-3106, DOI: 10.1109/LED.2005.848070
- PABLO EDUARDO ACOSTA-ALBA ET AL: "Smoothening by Self-Diffusion of Silicon during Annealing in a Rapid Processing Chamber", GETTERING AND DEFECT ENGINEERING IN SEMICONDUCTOR TECHNOLOGY XIV ; SELECTED PAPERS FROM THE XIVTH INTERNATIONAL BIANNUAL MEETING ON GETTERING AND DEFECT ENGINEERING IN SEMICONDUCTOR, (GADEST2011), SEPTEMBER 25 - 30, 2011, LOIPERSDORF (FÜRSTENFELD), A, vol. 205-206, 1 octobre 2013 (2013-10-01), pages 364-369, XP055642760, CH ISSN: 1012-0394, DOI: 10.4028/www.scientific.net/SSP.205-206.364 ISBN: 978-3-03785-232-3

## Description

### DOMAINE DE L'INVENTION

La présente invention concerne un procédé de fabrication d'un dispositif CFET.

### ETAT DE LA TECHNIQUE

Un dispositif CFET (acronyme du terme anglo-saxon « Complementary Field Effect Transistor ») peut être défini comme une structure à transistors à effet de champ à ailettes (plus connus sous l'acronyme anglo-saxon « FinFET ») complémentaires. Autrement dit, c'est un dispositif électronique tridimensionnel consistant à empiler deux transistors FinFET de types différents, par exemple un transistor de type N (dit « NFET ») sur un transistor de type P (dit « PFET »).

Un tel empilement permet de réduire l'encombrement surfacique du dispositif et donc d'augmenter la densité de transistors par unité de surface.

De manière conventionnelle, un dispositif CFET est réalisé à partir d'un substrat massif de silicium monocristallin intégrant une couche sacrificielle enterrée. Cette couche sacrificielle peut être, par exemple, une couche de Silicium-Germanium (SiGe), dans lequel on grave des tranchées profondes verticales qui permettent de délimiter les différentes ailettes des transistors. La gravure sélective de la couche sacrificielle permet la séparation physique verticale de ces deux transistors FinFET de type N et de type P.

Les zones actives destinées à former les régions source et drain des transistors FinFET complémentaires peuvent être dopées N et P, par exemple par implantation sélective dans l'épaisseur de la structure ainsi formée.

Par ailleurs, selon le type d'application visée, les canaux pourraient être dopés N ou P. Ce dopage peut être également réalisé par implantation sélective dans l'épaisseur de la structure.

La réduction de la largeur des ailettes doit s'accompagner d'une augmentation de la hauteur des zones actives, notamment des canaux pour permettre l'augmentation de la quantité de courant électrique à faire passer.

Cependant, il existe des limitations technologiques à la fabrication des ailettes, notamment en termes de ratio hauteur / largeur, de sorte que la densité de transistors par unité de surface tout en gardant des performances électriques acceptables tend vers un seuil.

Un exemple de procédé de fabrication d'un tel dispositif CFET est fourni dans le brevet US 9812575-B1.

### EXPOSE DE L'INVENTION

Un but de l'invention est d'améliorer la conception et la fabrication des dispositifs CFET.

A cet effet, l'invention propose un procédé de fabrication d'un dispositif CFET, tel que défini par la revendication 1.

Selon des caractéristiques avantageuses mais optionnelles de ce procédé, considérées seules ou en combinaison lorsque cela est techniquement approprié :
- les tranchées sont formées par gravure, la première couche électriquement isolante constituant une couche d'arrêt de ladite gravure ;
- l'épaisseur des première et seconde couches semi-conductrices monocristallines est comprise entre 25 et 40 nm ;
- le traitement thermique de lissage de la première couche semi-conductrice monocristalline est mis en oeuvre à une température comprise entre 1000 et 1200°C, pendant une durée comprise entre 10 et 120 minutes ;
- le procédé comprend en outre un traitement thermique de finition de la seconde couche semi-conductrice monocristalline à une température comprise entre 1100 et 1250°C, pendant une durée inférieure à une minute.

Le dispositif CFET ainsi formé comprend un substrat support et au moins une ailette s'étendant à partir du substrat support, dans laquelle sont agencés deux transistors à effet de champ de types opposés superposés, ledit dispositif étant caractérisé en ce que chaque ailette comprend, à partir du substrat support :
- une première couche électriquement isolante ;
- une première couche semi-conductrice monocristalline, formant le canal d'un premier transistor ;
- une seconde couche électriquement isolante ;
- une seconde couche semi-conductrice monocristalline, formant le canal d'un second transistor.

Par « superposés » on entend un empilement des transistors dans une direction perpendiculaire à la surface principale du substrat support.

En ce qui concerne la première et la seconde couche semi-conductrice, les modes de réalisation ci-après sont envisageables, éventuellement en combinaison lorsque cela est techniquement pertinent :
- la première et la seconde couche semi-conductrice sont en silicium dopé de types opposés ;
- la première et la seconde couche semi-conductrice sont en silicium présentant des orientations cristallines différentes ;
- la première et la seconde couche semi-conductrice sont en des matériaux différents ;
- la couche semi-conductrice dans laquelle est formé le canal d'un transistor de type N est en silicium contraint ;
- la couche semi-conductrice dans laquelle est formé le canal d'un transistor de type P est en silicium-germanium.

En ce qui concerne la première et la seconde couche électriquement isolante, les modes de réalisation ci-après sont envisageables, éventuellement en combinaison lorsque cela est techniquement pertinent :
- la première et/ou la seconde couche électriquement isolante sont en oxyde de silicium (SiO₂) ;
- la première et la seconde couche électriquement isolante sont en des matériaux différents ;
- la première couche électriquement isolante est en un matériau à constante diélectrique élevée (« high k ») ;
- la seconde couche électriquement isolante est en un matériau à constante diélectrique faible (« low k »).

Selon une forme d'exécution, le substrat support comprend au moins une couche additionnelle choisie parmi les couches suivantes :
- une couche de piégeage de charges ;
- une couche semi-conductrice épitaxiale ;
- une couche de silicium de type CZ « COP-free », c'est-à-dire dépourvue de défauts cristallins de type COPs.

Dans certains modes de réalisation, la fabrication d'un dispositif CFET, peut comprendre :
- la formation d'un substrat de type double semi-conducteur sur isolant comprenant successivement, de sa base vers sa surface : un substrat support incluant une couche fonctionnelle (telle qu'une couche de silicium polycristallin, une couche de silicium monocristallin dite « COP-free » ou une couche semi-conductrice épitaxiale, éventuellement dopée), une première couche électriquement isolante, une première couche semi-conductrice monocristalline, une seconde couche électriquement isolante et une seconde couche semi-conductrice monocristalline ;
- la formation de tranchées à partir de la surface dudit substrat, jusqu'à la première couche électriquement isolante, de sorte à former au moins une ailette,
- dans chaque ailette, la formation d'un canal d'un premier transistor dans la première couche semi-conductrice et d'un canal d'un second transistor de type opposé au premier transistor dans la seconde couche semi-conductrice,
la formation du substrat de type double semi-conducteur sur isolant comprenant :
- une première étape de transfert de couche pour transférer la première couche électriquement isolante et la première couche semi-conductrice monocristalline sur le substrat support, de sorte à former un premier substrat de type semi-conducteur sur isolant, à partir d'un premier substrat donneur comprenant une couche adaptée pour être gravée sélectivement par rapport à la première couche semi-conductrice monocristalline (lesdites couches peuvent avantageusement être créées par épitaxie) et une zone de fragilisation (pouvant avantageusement être formée par implantation d'espèces atomiques) située à une profondeur du premier substrat donneur strictement supérieure à l'épaisseur des deux couches susmentionnées,
- après gravure sélective de la couche adaptée pour être gravée sélectivement par rapport à la première couche semi-conductrice monocristalline, une deuxième étape de transfert de couche pour transférer la seconde couche électriquement isolante et la seconde couche semi-conductrice monocristalline sur la première couche semi-conductrice monocristalline du premier substrat de type semi-conducteur sur isolant.

De manière particulièrement avantageuse, ledit procédé ne met pas en oeuvre de budget thermique susceptible d'endommager la couche fonctionnelle mais permet d'obtenir une rugosité de la première couche semi-conductrice monocristalline inférieure à 0,1 nm RMS.

### BREVE DESCRIPTION DES FIGURES

D'autres caractéristiques et avantages de l'invention ressortiront de la description détaillée qui va suivre, en référence aux dessins annexés sur lesquels :
- la figure 1 est une vue en coupe schématique d'un dispositif CFET selon un mode de réalisation ;
- la figure 2 est une vue en coupe schématique d'un dispositif CFET selon un autre mode de réalisation, dans lequel le substrat support comprend une couche fonctionnelle,
- les figures 3A à 3F illustrent de manière schématique différentes étapes de fabrication d'un substrat de type double semi-conducteur sur isolant adapté pour la formation d'un dispositif CFET.

Pour des raisons de lisibilité des figures, les différentes couches ne sont pas nécessairement représentées à l'échelle.

Les signes de référence identiques d'une figure à l'autre désignent des éléments identiques ou remplissant la même fonction.

### DESCRIPTION DETAILLEE DE MODES DE REALISATION DE L'INVENTION

L'invention propose de remplacer, pour former un dispositif CFET, le substrat de silicium massif susmentionné par un substrat de type semi-conducteur sur isolant comprenant un substrat support, deux couches semi-conductrices monocristallines et deux couches électriquement isolantes séparant respectivement les deux couches semi-conductrices d'une part et le substrat support et la couche semi-conductrice la plus proche dudit substrat support d'autre part.

Un tel substrat de type semi-conducteur sur isolant est qualifié de « double SOI » en raison de la présence des deux paires de couches semi-conductrices et de couches électriquement isolantes, par rapport à un substrat SOI (acronyme du terme anglo-saxon « Silicon On Insulator ») classique qui comprend une couche semi-conductrice monocristalline et une couche électriquement isolante intercalée entre le substrat support et la couche semi-conductrice.

Le substrat support peut être réalisé en un matériau semi-conducteur (par exemple du silicium) ou en un autre matériau, selon qu'il doive assurer uniquement une fonction de support mécanique ou une fonction électrique au sein du dispositif.

Un tel substrat « double SOI » peut être fabriqué par deux transferts successifs d'une couche semi-conductrice monocristalline vers le substrat support. On peut en particulier utiliser le procédé Smart Cut^{™} qui comprend les étapes suivantes :
- fourniture du substrat support,
- fourniture d'un premier substrat donneur semi-conducteur monocristallin,
- formation d'une zone de fragilisation dans ledit substrat donneur, pour y délimiter une première couche mince superficielle (ladite zone de fragilisation pouvant être formée par implantation d'espèces atomiques à une profondeur déterminée du substrat donneur),
- collage du premier substrat donneur sur le substrat support, une première couche électriquement isolante étant à l'interface de collage,
- détachement du premier substrat donneur le long de la zone de fragilisation, conduisant au transfert de la première couche mince sur le substrat support (obtention d'un SOI),
- réalisation d'un traitement de finition de la première couche transférée, pour réparer ou retirer les défauts liés à l'étape de détachement et conférer à ladite couche les caractéristiques finales de rugosité et d'épaisseur souhaitées,
- fourniture d'un second substrat donneur semi-conducteur monocristallin, pouvant être identique au premier ou différent,
- formation d'une zone de fragilisation dans ledit second substrat donneur, pour y délimiter une seconde couche mince superficielle,
- collage du second substrat donneur sur le SOI précédemment formé, une seconde couche électriquement isolante étant à l'interface de collage entre la première couche semi-conductrice transférée et le second substrat donneur,
- détachement du second substrat donneur le long de la zone de fragilisation, conduisant au transfert de la seconde couche mince sur le substrat support (obtention du double SOI),
- réalisation d'un traitement de finition de la seconde couche transférée, pour réparer ou retirer les défauts liés à l'étape de détachement et conférer à ladite couche les caractéristiques finales de rugosité et d'épaisseur souhaitées.

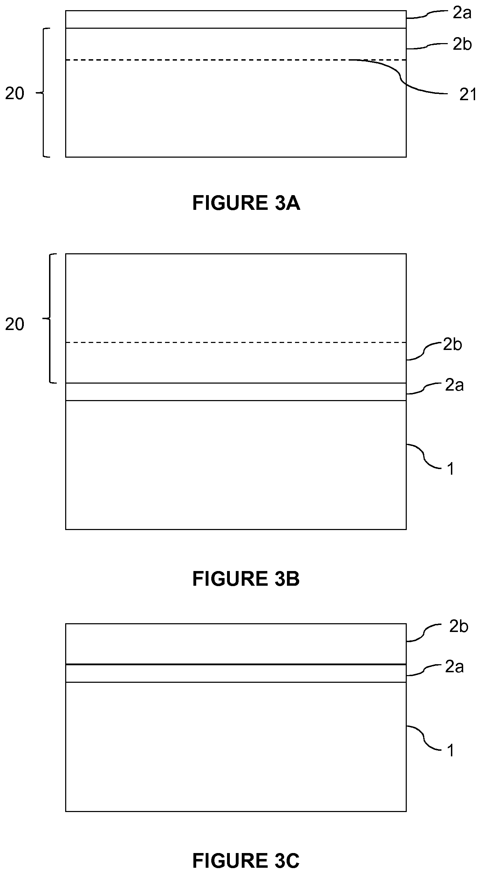

Des détails de mise en oeuvre de ce procédé seront décrits plus bas en référence aux figures 3A-3F.

Chacune des couches semi-conductrices monocristallines est destinée à former les zones actives (source, drain et canal) d'un transistor FinFET respectif, les deux transistors étant de types opposés. Par exemple, la zone active d'un transistor PFET est formée dans la première couche semi-conductrice monocristalline, qui est la plus proche du substrat support, et la zone active d'un transistor NFET est formée dans la seconde couche semi-conductrice monocristalline, qui est la plus éloignée du substrat support. Inversement, selon un autre exemple, la zone active d'un transistor NFET peut être formée dans la première couche semi-conductrice monocristalline et la zone active d'un transistor PFET peut être formée dans la seconde couche semi-conductrice monocristalline.

De manière connue en elle-même, une gravure sèche est mise en oeuvre sur le substrat double SOI pour former des tranchées permettant de délimiter des ailettes parallèles.

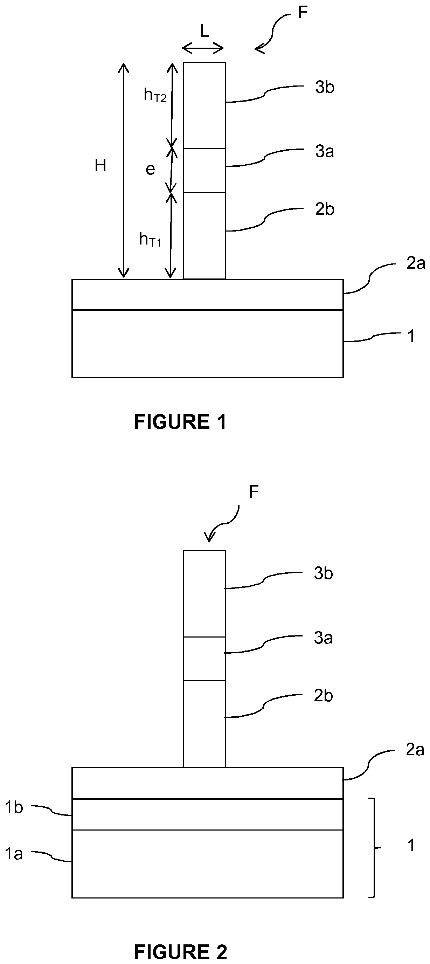

Dans le présent texte, on entend par « largeur » (notée L sur la figure 1) d'une ailette sa dimension dans une direction parallèle à une surface principale du substrat support, qui définit la largeur du canal, et par « hauteur » (notée H sur la figure 1) sa dimension dans une direction perpendiculaire à la surface principale du substrat support, c'est-à-dire dans la direction de l'épaisseur du substrat double SOI. La longueur du canal s'étend dans une direction perpendiculaire aux dimensions L et H et est déterminée par la distance entre la source et le drain, qui sont distribués selon cette direction.

Par rapport au dispositif CFET connu, l'utilisation d'un substrat double SOI présente plusieurs avantages.

D'une part, la hauteur (notée h_{T1} et h_{T2} sur la figure 1) des canaux N et P est égale à l'épaisseur des couches semi-conductrices dans lesquelles ils sont formés ; cette hauteur est donc maîtrisée très précisément du fait de la qualité du procédé de transfert de couche qui procure une grande précision et une grande uniformité de l'épaisseur de la couche semi-conductrice transférée et de la couche électriquement isolante. L'épaisseur des couches semi-conductrices transférées après l'étape de finition pourra être comprise par exemple entre 4 et 100 nm, avec un contrôle de cette épaisseur jusqu'à +/- 0,5 nm autour de l'objectif visé. L'épaisseur des couches électriquement isolantes créées pourra être comprise par exemple entre 10 et 200 nm (la borne de 200 nm s'appliquant en particulier pour la première couche électriquement isolante, la couche seconde couche électriquement isolante étant avantageusement beaucoup plus fine), avec un contrôle de cette épaisseur jusqu'à +/- 1 nm autour de l'objectif visé. Le contrôle de la variabilité de l'épaisseur des couches transférées / créées est justifié par leurs effets bien connus de l'homme de l'art sur la variabilité des transistors. Dans le dispositif CFET de l'art antérieur, la hauteur des canaux est définie par des gravures horizontales qui sont moins bien maîtrisées.

D'autre part, les canaux N et P sont séparés par une couche qui non seulement constitue une frontière physique mais aussi procure une isolation électrique desdits canaux. De même, le canal du transistor le plus proche du substrat support est isolé physiquement et électriquement dudit substrat support.

En outre, la première couche électriquement isolante constitue avantageusement une couche d'arrêt de gravure lors de la formation des tranchées.

Par ailleurs, le procédé de fabrication du substrat double SOI permet de varier les matériaux des couches semi-conductrices monocristallines et des couches électriquement isolantes pour les adapter aux performances recherchées.

Ainsi, dans un mode de réalisation, les deux couches semi-conductrices monocristallines sont toutes deux en silicium, mais avec des types de dopage différents. De manière préférentielle, les deux couches sont faiblement dopées, c'est-à-dire avec une concentration en dopants inférieure ou égale à 10^{e}15 at/cm³.

Dans un autre mode de réalisation ou de façon combinée avec le précédent, les couches semi-conductrices monocristallines sont toutes deux en silicium, mais avec des orientations cristallines différentes. Ceci permet d'optimiser la mobilité des porteurs dans chacun des deux transistors FinFET : en effet, l'orientation cristalline de la zone active qui procure une meilleure mobilité des porteurs pour un transistor de type N est différente de l'orientation cristalline optimale qui procure une meilleure mobilité des porteurs pour un transistor de type P.

Dans un autre mode de réalisation, les couches semi-conductrices monocristallines sont en des matériaux différents.

Par exemple, pour un transistor NFET, le silicium peut être avantageusement remplacé par du silicium contraint. Pour un transistor PFET, le silicium peut être avantageusement remplacé par du silicium-germanium. Ces matériaux alternatifs permettent d'augmenter la mobilité des porteurs de charge dans le canal du transistor respectif.

Le choix du matériau de chaque couche semi-conductrice nécessite uniquement l'emploi d'un substrat donneur adéquat lors de la fabrication du substrat double SOI.

Par ailleurs, le dopage N ou P peut être réalisé avant le transfert de chaque couche semi-conductrice sur le substrat support, ce qui évite d'endommager le dispositif avec une implantation ultérieure de dopants.

Dans un mode de réalisation, les deux couches électriquement isolantes sont dans le même matériau, par exemple de l'oxyde de silicium (SiO₂). Lesdites couches d'oxyde sont obtenues classiquement par oxydation thermique d'un substrat de silicium.

De manière alternative, les deux couches électriquement isolantes sont dans des matériaux différents.

Ainsi, selon un mode de réalisation, la première couche électriquement isolante peut être réalisée en un matériau dit « high k », c'est-à-dire à constante diélectrique élevée, tels que par exemple et de façon non limitative l'oxyde d'hafnium ou l'oxyde de zirconium (notamment HfO2, HfON, HfSiO, HfSiON, ZrO₂, HfZrO₂, ou HfZrO). Par rapport à l'oxyde de silicium, un tel matériau peut présenter une fonction d'arrêt de gravure améliorée du fait d'une plus grande sélectivité vis-à-vis du matériau de la première couche semi-conductrice monocristalline.

Selon un mode de réalisation, la seconde couche électriquement isolante peut être réalisée en un matériau dit « low k », c'est-à-dire à constante diélectrique faible tel que par exemple et de façon non limitative l'oxyde de silicium dopé carbone et/ou fluor (notamment SiOC, SiOF, SiOCF, SiOCH), mais aussi un oxyde poreux ou un matériau organique (par exemple polytétrafluoroéthylène (PTFE), polyimide, parylène). Par rapport à une couche d'oxyde de silicium, et pour une même performance d'isolation électrique, une couche d'un tel matériau est plus fine (le ratio entre les épaisseurs des couches de ces deux matériaux correspondant au ratio entre leurs permittivités diélectriques). Cette configuration est particulièrement avantageuse car, comme mentionné plus haut, l'augmentation de la densité, tout en gardant un niveau acceptable des performances électriques des transistors, est limitée par le ratio hauteur / largeur des ailettes, ainsi que par l'espacement nécessaire entre les ailettes. Pour une même hauteur des ailettes, la réduction de l'épaisseur (notée e sur la figure 1) de la seconde couche électriquement isolante bénéficie donc aux zones actives, notamment aux canaux qui peuvent présenter une hauteur (h_{T1}, h_{T2}) plus grande et par conséquent une meilleure performance en courant. Par exemple, une couche de 20 nm de SiO₂ séparant deux canaux de 30 nm de hauteur peut être remplacée par une couche de 10 nm de SiO₂ poreux dopé au carbone ; le gain en hauteur pour les deux canaux est donc de 10 nm au total, soit une augmentation de près de 20% de la hauteur de chaque canal.

Les différentes options de matériaux décrites ci-dessus pour les couches électriquement isolantes et les couches semi-conductrices monocristallines peuvent être librement combinées par l'homme du métier en fonction des spécificités du dispositif et des performances recherchées.

Un autre avantage du substrat double SOI est que le substrat support lui-même peut être fonctionnalisé. En d'autres termes, le substrat support ne remplit pas qu'une fonction de support mécanique des transistors, mais il peut comprendre une ou plusieurs couches remplissant un rôle particulier dans le fonctionnement du dispositif, ou un ou plusieurs composants électroniques permettant au dispositif de remplir plusieurs fonctions sur le modèle d'un « System on Chip » (système sur une puce). Une telle fonctionnalisation du substrat support peut être réalisée pendant ou en particulier avant la fabrication du substrat double SOI au travers du choix du substrat support.

Par exemple, le substrat support peut comprendre une couche de piégeage de charges électriques, qui peut se présenter sous la forme d'une couche de silicium polycristallin. Une telle couche est particulièrement utile pour le fonctionnement d'un dispositif radiofréquence, qui peut donc être combiné au dispositif CFET permettant ainsi d'intégrer sur une même puce des composants destinés à de la logique et du calcul ainsi que des composants radiofréquences (RF) nécessaires pour gérer la connectivité. La couche comportant de nombreux pièges électriques limite l'auto-polarisation et les distorsions entre transistors véhiculées par le substrat (induites par le fort rayonnement électromagnétique des transistors radiofréquences). Cette couche permet de réduire ces interférences en piégeant les charges électriques. Dans ce cas précis, un double SOI est nécessaire car une couche électriquement isolante doit être intercalée entre la couche à base de piège et la couche utile.

Selon un autre exemple, éventuellement combiné au précédent, le substrat support peut comprendre une couche présentant une qualité particulière, par exemple une couche de silicium dépourvue de défauts appelés COPs (acronyme du terme anglo-saxon « Crystal Originated Pits »). Cette couche peut être une couche de type CZ (Czochralski) qualifiée « COP-free » dans la littérature (cf. page 27 de l'ouvrage Silicon-on-Insulator Technology and Devices XI, Electrochemical Society Proceedings, Volume 2003-05), ou une couche semi-conductrice épitaxiale, éventuellement dopée.

Une telle couche permet en particulier d'intégrer une mémoire embarquée de type DRAM (e-DRAM, acronyme du terme anglo-saxon « embedded Dynamic Random Access Memory »). Les mémoires DRAM embarquées permettent de réduire fortement la latence (de l'ordre d'un facteur 3) entre la mémoire locale et la mémoire système en intégrant cette dernière (en partie) directement sur la puce, plutôt que dans des modules séparés. Pour cela, la mémoire DRAM embarquée remplace également une partie de la mémoire statique (dite SRAM). La fabrication d'une mémoire DRAM embarquée à côté d'un circuit logique consiste à enterrer les capacités créant l'effet mémoire dans le substrat. La couche dans laquelle sont fabriquées les capacités doit être dopée.

La figure 1 est une vue en coupe schématique d'un dispositif CFET selon un mode de réalisation de l'invention.

Le dispositif comprend un substrat support 1. Ledit substrat support peut être en silicium massif ou en tout autre matériau pouvant servir de support mécanique au dispositif.

Le substrat support 1 est recouvert d'une première couche 2a électriquement isolante. De manière avantageuse, ladite couche 2a a servi de couche d'arrêt de gravure lors de la formation de l'ailette F, de sorte qu'elle s'étend sur sensiblement toute la surface du substrat support 1. Cependant, il n'est pas exclu qu'entre deux ailettes le matériau de la couche 2a ait été partiellement ou totalement retiré. La couche 2a peut être en oxyde de silicium ou en un autre matériau électriquement isolant, choisi notamment pour sa sélectivité vis-à-vis de la gravure. La couche 2a peut ainsi être avantageusement en un diélectrique high k.

L'ailette F comprend, sur la première couche électriquement isolante 2a, une première couche 2b semi-conductrice monocristalline qui forme le canal d'un premier transistor. La hauteur h_{T1} dudit canal est égale à l'épaisseur de la couche 2b. La couche 2b est par exemple dopée P, et préférentiellement faiblement dopée P. Elle peut être en silicium ou en un autre matériau semi-conducteur, qui peut être choisi notamment pour maximiser la mobilité des porteurs de charge dans ladite couche. Ainsi, la couche 2b peut avantageusement être en silicium-germanium si le transistor est de type P.

L'ailette comprend, sur la première couche semi-conductrice 2b, une seconde couche électriquement isolante 3a. La couche 3a peut être en oxyde de silicium ou en un autre matériau électriquement isolant, choisi notamment pour sa faible permittivité diélectrique, permettant de minimiser l'épaisseur a de ladite couche 3a et maximiser, en contrepartie, la hauteur des canaux des deux transistors. La couche 3a peut ainsi être avantageusement en un diélectrique low k, par exemple du SiO₂ poreux dopé au carbone.

Enfin, l'ailette comprend, sur la seconde couche électriquement isolante 3a, une seconde couche 3b semi-conductrice monocristalline qui forme le canal d'un premier transistor. La hauteur h_{T2} dudit canal est égale à l'épaisseur de la couche 3b. La couche 3b est par exemple dopée N, et préférentiellement faiblement dopée N. Elle peut être en silicium ou en un autre matériau semi-conducteur, qui peut être choisi notamment pour maximiser la mobilité des porteurs de charge dans ladite couche. Ainsi, la couche 3b peut avantageusement être en silicium contraint si le transistor est de type N.

La figure 2 est une vue en coupe schématique d'un dispositif CFET selon un autre mode de réalisation de l'invention.

Par rapport à la figure 1, le dispositif CFET de la figure 2 comprend en outre une couche fonctionnelle incluse dans le substrat support. Le substrat support 1 comprend ainsi un substrat de base 1a, par exemple en silicium massif, ou en tout autre matériau pouvant servir de support mécanique au dispositif, et une couche fonctionnelle 1b agencée entre le substrat de base 1a et la première couche électriquement isolante 2a.

La couche fonctionnelle 1b peut être notamment :
- une couche de silicium polycristallin, remplissant une fonction de piégeage de charges notamment dans les dispositifs radiofréquence ;
- une couche de silicium monocristallin dite « COP-free », c'est-à-dire dépourvue ou présentant une très faible densité de cavités au sein du réseau cristallin ;
- une couche semi-conductrice épitaxiale, éventuellement dopée (par exemple Si dopé carbone, Si dopé Phosphore, Si dopé Bore, ou encore SiGe).

Dans un souci de simplification des figures, une seule ailette F a été représentée, mais il va de soi qu'un dispositif CFET comprend en principe un grand nombre d'ailettes s'étendant parallèlement les unes aux autres à partir du substrat support.

Les figures 3A-3F illustrent de manière schématique différentes étapes d'un procédé de fabrication d'un substrat double SOI adapté pour la réalisation des dispositifs CFET décrits plus haut.

La fabrication d'un tel substrat double SOI par un double transfert de couche de type Smart Cut^{™} doit répondre à certaines contraintes techniques qui sont propres à la réalisation de dispositifs CFET.

En particulier, la gravure des tranchées dans le substrat double SOI permettant de délimiter chaque ailette doit être réalisée en une seule étape afin de garantir l'alignement des dispositifs et leur espacement. En pratique, une telle gravure peut être réalisée sur une profondeur n'excédant pas 90 nm, par exemple sur une épaisseur comprise entre 60 et 90 nm.

Dans la mesure où on cherche par ailleurs à maximiser l'épaisseur des canaux N et P, afin de maximiser la quantité de courant, l'épaisseur des couches semi-conductrices monocristallines 2b et 3b doit être typiquement de l'ordre de 25 à 40 nm, l'épaisseur de la couche électriquement isolante 3a intercalée entre lesdites couches étant quant à elle comprise entre 10 et 30 nm.

La finesse de ces couches impose donc des contraintes particulières sur le procédé de transfert de couche pour assurer une défectivité compatible avec les performances attendues du dispositif CFET.

En particulier, la fine épaisseur de la couche électriquement isolante 3a requiert que la surface de la couche sur laquelle ladite couche électriquement isolante doit être collée (c'est-à-dire la première couche semi-conductrice monocristalline 2b) présente une rugosité inférieure à 0,1 nm RMS (acronyme du terme anglo-saxon « Root Mean Square ») et une densité de défauts de 50 nm de taille aussi faible que possible.

Par ailleurs, la variabilité de l'épaisseur de chaque couche semi-conductrice monocristalline destinée à former un canal N ou P se doit d'être extrêmement faible, de l'ordre de ± 1,5 nm par rapport à l'épaisseur cible. Une variabilité aussi faible ne peut être obtenue au moyen d'un procédé de polissage mécano-chimique (CMP) classiquement utilisé pour polir des surfaces semi-conductrices, servant notamment de substrat receveur dans le procédé Smart Cut^{™}.

Pour remédier à ces difficultés, il est proposé de mettre en oeuvre dans la première étape de transfert de couche un procédé employé habituellement pour former un substrat SOI totalement déplété (FDSOI, acronyme du terme anglo-saxon « Fully Depleted SOI »), comprenant un traitement thermique à haute température pour lisser la surface de la couche transférée de sorte à atteindre la rugosité requise. Cette rugosité est équivalente à celle obtenue par un polissage mécano-chimique mais permet de conserver la variabilité requise de l'épaisseur de la couche transférée.

On pourra se référer notamment à l'article de W. Schwarzenbach et al, ECS Trans. 53, p. 39 (2013) pour un graphe de la densité spectrale de puissance (PSD, acronyme du terme anglo-saxon « Power Spectral Density ») pour une surface de 30 µm x 30 µm en fonction de la fréquence spatiale des défauts.

Cependant, par rapport au procédé connu pour former un substrat FDSOI planaire, il peut être avantageux dans cette option de supprimer le procédé de nettoyage pas à pas, typiquement inclus dans le procédé de fabrication d'un substrat FDSOI et décrit dans la référence W. Schwarzenbach et al, IEEE ICICDT proceeding, 2011, étant donné que celui-ci apparaît superflu dans la mesure où la variabilité d'épaisseur requise pour un dispositif CFET est supérieure à la variabilité généralement recherchée dans un substrat FDSOI planaire (qui est de l'ordre de ± 0,5 nm par rapport à l'épaisseur cible). La suppression de cette étape de nettoyage permet de minimiser le coût du procédé de fabrication tout en préservant la qualité requise pour la première couche semi-conductrice 2b.

En ce qui concerne la deuxième étape de transfert de couche, elle peut être mise en oeuvre dans les mêmes conditions que la première étape, ou bien selon un procédé utilisé pour former un substrat SOI partiellement déplété (PDSOI, acronyme du terme anglo-saxon « Partially Depleted SOI »).

Selon la première option, la demanderesse a mis en évidence que le traitement thermique de lissage de longue durée n'engendre pas de dissolution de l'oxyde de la couches électriquement isolante 2a, suivant le procédé physique décrit dans l'article de O. Kononchuck et al, Solid State Phenomena, vol 131-133, pp 113-118, 2008.

Les figures 3A-3C illustrent de manière schématique la première étape de transfert de couche.

En référence à la figure 3A, on fournit un premier substrat donneur semi-conducteur monocristallin 20, dans lequel on forme une zone de fragilisation 21 destinée à y délimiter une première couche mince superficielle destinée à former la couche 2b du dispositif CFET.

De manière connue en elle-même, ladite zone de fragilisation peut être formée par implantation d'espèces atomiques, telles que de l'hydrogène et/ou de l'hélium, à une profondeur déterminée du substrat donneur 20.

De manière avantageuse, le substrat donneur 20 peut avoir été préalablement recouvert d'une couche électriquement isolante, destinée à former au moins une partie de la couche 2a du dispositif CFET.

En référence à la figure 3B, on colle le premier substrat donneur 20 sur le substrat support 1, la première couche électriquement isolante 2a étant à l'interface de collage. Bien que cela ne soit pas illustré sur la figure 3B, le substrat support peut être recouvert d'une couche électriquement isolante destinée à former au moins une partie de la couche 2a du dispositif CFET, en combinaison avec la couche électriquement isolante éventuellement présente à la surface du premier substrat donneur 20.

En référence à la figure 3C, on détache le premier substrat donneur 20 le long de la zone de fragilisation 21, de sorte à transférer la couche 2b sur le substrat support.

Comme indiqué plus haut, on met en oeuvre, sur le premier substrat SOI ainsi formé, un traitement de finition de la couche transférée 2b, pour réparer ou retirer les défauts liés à l'étape de détachement et conférer à ladite couche les caractéristiques finales de rugosité et d'épaisseur souhaitées. Un tel traitement comprend en particulier un traitement thermique à haute température, typiquement comprise entre 1000 et 1200°C, pendant une durée relativement longue, typiquement comprise entre 10 et 120 minutes. Ce traitement thermique a pour effet de lisser la surface, jusqu'à atteindre une rugosité inférieure à 0,1 nm RMS.

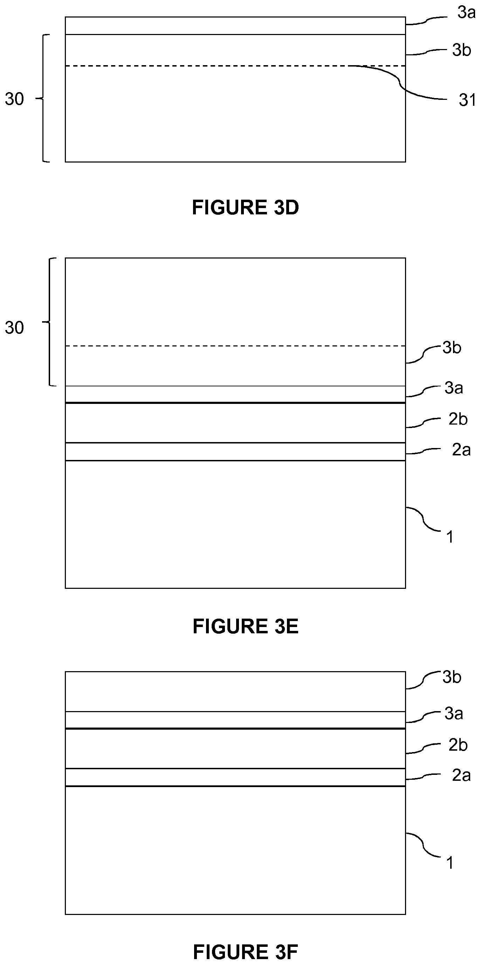

Les figures 3D-3F illustrent de manière schématique la deuxième étape de transfert de couche.

En référence à la figure 3D, on fournit un second substrat donneur semi-conducteur monocristallin 30, dans lequel on forme une zone de fragilisation 31 destinée à y délimiter une première couche mince superficielle destinée à former la couche 3b du dispositif CFET. Bien que le second substrat donneur soit désigné par un signe de référence différent de celui du premier substrat donneur 20, il peut s'agir du même substrat, le premier substrat donneur ayant été traité après le détachement pour éliminer les défauts liés à l'implantation. Cependant, de manière avantageuse, les matériaux du premier et du second substrat donneur sont différents (par exemple en termes de composition, d'orientation cristallographique, de dopage et/ou de contrainte) et choisis en fonction de la nature du canal qu'ils sont destinés à former.

De manière connue en elle-même, ladite zone de fragilisation peut être formée par implantation d'espèces atomiques, telles que de l'hydrogène et/ou de l'hélium, à une profondeur déterminée du substrat donneur 30.

De manière avantageuse, le substrat donneur 30 peut avoir été préalablement recouvert d'une couche électriquement isolante, destinée à former au moins une partie de la couche 3a du dispositif CFET.

En référence à la figure 3E, on colle le premier substrat donneur 30 sur le substrat substrat SOI obtenu à l'issue de la première étape de transfert de couche, la première couche électriquement isolante 3a étant à l'interface de collage.

En référence à la figure 3F, on détache le second substrat donneur 30 le long de la zone de fragilisation 31, de sorte à transférer la couche 2b sur le substrat SOI.

Comme indiqué plus haut, selon un mode de réalisation (du type d'un procédé de fabrication d'un substrat FDSOI), on met en oeuvre, sur le substrat double SOI ainsi formé, un traitement de finition de la couche transférée 3b, pour réparer ou retirer les défauts liés à l'étape de détachement et conférer à ladite couche les caractéristiques finales de rugosité et d'épaisseur souhaitées. Un tel traitement comprend en particulier un traitement thermique à haute température, typiquement comprise entre 1000 et 1200°C, pendant une durée relativement longue, typiquement comprise entre 10 et 120 minutes. Ce traitement thermique a pour effet de lisser la surface, jusqu'à atteindre une rugosité inférieure à 0,1 nm RMS.

Selon un autre mode de réalisation (du type d'un procédé de fabrication d'un substrat PDSOI) on met en oeuvre, sur le substrat double SOI ainsi formé, un traitement de finition de la couche transférée 3b, pour réparer ou retirer les défauts liés à l'étape de détachement et conférer à ladite couche les caractéristiques finales de rugosité et d'épaisseur souhaitées. Un tel traitement comprend en particulier des traitements thermiques à haute température, typiquement comprise entre 1100 et 1250°C, pendant une durée relativement courte, typiquement inférieure à une minute. Ces traitements thermiques ont pour effet de lisser la surface, jusqu'à atteindre une rugosité inférieure à 0,5 nm RMS

Ensuite, on forme par gravure des tranchées dans le substrat double SOI jusqu'à la première couche électriquement isolante 2a, de sorte à délimiter une ou plusieurs ailettes telles qu'illustrées sur la figure 1. Lors de cette gravure, la couche 2a joue avantageusement le rôle de couche d'arrêt de gravure.

Dans certaines formes d'exécution, il peut être avantageux d'inclure une couche fonctionnelle 1b dans le substrat support 1, comme illustré sur la figure 2.

Dans ce cas, le budget thermique mis en oeuvre dans la fabrication du substrat double SOI peut être critique. En effet, si la couche fonctionnelle 1b comprend du silicium polycristallin, l'application d'un traitement thermique à haute température pour lisser la couche semi-conductrice 2b peut provoquer la recristallisation du silicium polycristallin de la couche 1b, lui faisant ainsi perdre tout ou partie de ses propriétés de piégeage de charges. Dans un autre exemple, si la couche fonctionnelle 1b est dopée, l'application d'un traitement thermique à haute température pour lisser la couche semi-conductrice 2b peut provoquer la diffusion du dopant au sein du substrat SOI, ne permettant pas d'intégrer une mémoire e-DRAM.

Dans cette éventualité, il est avantageux d'utiliser, pour former la couche 2b, un procédé de transfert de couche permettant d'obtenir une très faible rugosité et une faible défectivité avec un budget thermique limité. Un tel procédé peut être mis en oeuvre dans les conditions suivantes : le substrat donneur 20 portera préférentiellement deux couches de matériaux, l'une devant servir de support à un procédé de gravure sélective, la seconde formant la couche 2b. Ces deux couches peuvent avantageusement être créées par épitaxie. Une zone de fragilisation peut être formée par implantation d'espèces atomiques, telles que de l'hydrogène et/ou de l'hélium, à une profondeur déterminée strictement supérieure à l'épaisseur des deux couches susmentionnées. De manière avantageuse, le substrat donneur 20 peut avoir été préalablement recouvert d'une couche électriquement isolante, destinée à former au moins une partie de la couche 2a du dispositif CFET.

En référence à la figure 3B, on colle le premier substrat donneur 20 sur le substrat support 1, la première couche électriquement isolante 2a étant à l'interface de collage. Bien que cela ne soit pas illustré sur la figure 3B, le substrat support peut être recouvert d'une couche électriquement isolante destinée à former au moins une partie de la couche 2a du dispositif CFET, en combinaison avec la couche électriquement isolante éventuellement présente à la surface du premier substrat donneur 20.

En référence à la figure 3C, on détache le premier substrat donneur 20 le long de la zone de fragilisation 21, de sorte à transférer la couche 2b sur le substrat support.

On met alors en oeuvre, sur le premier substrat SOI ainsi formé, un traitement de finition consistant en une gravure sélective s'arrêtant sur chacune des deux couches créées préalablement. Un tel traitement de finition ne comporte pas de procédé à une température supérieure à 500°C. Il permet de disposer, à l'issue, d'une surface dont la rugosité est inférieure à 0.1 nm RMS.

En ce qui concerne la couche 3b transférée lors de la deuxième étape de transfert de couche, les mêmes contraintes liées au budget thermique s'appliquent mais, comme indiqué plus haut, un procédé de type PDSOI est suffisant pour obtenir la qualité requise pour la couche 3b avec un traitement thermique ne détériorant pas les propriétés de la couche fonctionnelle 1b.

Dans le cas où la couche 2b est une couche de silicium-germanium (notamment dans le cas où cette couche est destinée à former le canal d'un transistor de type P), il peut être avantageux de former ladite couche de SiGe par épitaxie sur un substrat SOI. En effet, une couche épitaxiale de 30 nm de SiGe, dont la variabilité d'épaisseur est de l'ordre de 3%, permet de répondre au critère de variabilité du dispositif CFET. Un tel substrat de type silicium-germanium sur isolant (SiGeOI) créé par épitaxie sur un substrat SOI peut servir de substrat receveur lors de la deuxième étape de transfert de couche. Cette deuxième étape de transfert de couche peut avantageusement être conçue pour transférer une couche 3b de silicium contraint (destinée à former le canal d'un transistor de type N) sur le substrat SiGeOI.

Selon un mode de réalisation, le second substrat donneur peut comprendre une couche germe de SiGe et une couche épitaxiale de Si formée sur la couche germe, le SiGe imposant son paramètre de maille lors de la croissance du silicium, créant ainsi une contrainte dans ledit silicium. Ensuite, de manière connue en elle-même, on forme dans la couche de silicium germanium une zone de fragilisation destinée à délimiter la couche 3b à transférer, puis on colle le second substrat donneur sur le substrat SiGeOI par l'intermédiaire d'une couche électriquement isolante 3a. Ladite couche électriquement isolante peut notamment avoir été formée sur le silicium contraint avant l'implantation destinée à former la zone de fragilisation.

Selon un autre mode de réalisation, le second substrat donneur être constitué de silicium non contraint. De manière connue en elle-même, on forme dans le silicium une zone de fragilisation destinée à délimiter la couche 3b à transférer, puis on colle le second substrat donneur sur le substrat SiGeOI par l'intermédiaire une couche électriquement isolante 3a. Ladite couche électriquement isolante peut notamment avoir été formée sur le second substrat donneur avant l'implantation destinée à former la zone de fragilisation. La formation des tranchées destinées à séparer les ailettes a également pour effet de transférer au moins une partie de la contrainte de la couche 2b de SiGe (qui présente généralement une contrainte progressive due à sa formation par épitaxie sur un substrat SOI) vers la couche 3b de silicium. Dans le dispositif CFET ainsi obtenu, la couche 2b de SiGe est alors relaxée tandis que la couche 3b de silicium est contrainte.

### REFERENCES

W. Schwarzenbach et al, Atomic Scale Thickness Control of SOI Wafers for Fully Depleted Applications, ECS Trans. 53, p. 39 (2013)
W. Schwarzenbach et al, Excellent Silicon Thickness Uniformity Ultra-Thin SOI for controlling Vt variation of FDSOI, IEEE ICICDT proceeding, 2011
O. Kononchuck et al, Internal Dissolution of Buried Oxide in SOI Wafers, Solid State Phenomena, vol 131-133, pp 113-118, 2008

## Revendications

1. Procédé de fabrication d'un dispositif CFET, **caractérisé en ce qu'**il comprend :
- la formation d'un substrat de type double semi-conducteur sur isolant comprenant successivement, de sa base vers sa surface : un substrat support (1), une première couche (2a) électriquement isolante, une première couche (2b) semi-conductrice monocristalline, une seconde couche (3a) électriquement isolante présentant une épaisseur comprise entre 10 et 30 nm, et une seconde couche (3b) semi-conductrice monocristalline ;
- la formation de tranchées à partir de la surface dudit substrat, jusqu'à la première couche électriquement isolante (2a), de sorte à former au moins une ailette (F),
- dans chaque ailette (F), la formation d'un canal d'un premier transistor dans la première couche semi-conductrice (2b) et d'un canal d'un second transistor de type opposé au premier transistor dans la seconde couche semi-conductrice (3b),
la formation du substrat de type double semi-conducteur sur isolant comprenant :
- une première étape de transfert de couche comprenant une implantation d'espèces atomiques dans un premier substrat donneur (20) pour y former une zone de fragilisation (21), un collage dudit premier substrat donneur (20) sur le substrat support (1), la première couche électriquement isolante (2a) étant à l'interface de collage entre le premier substrat donneur (20) et le substrat support (1), et un détachement du premier substrat donneur (20) le long de la zone de fragilisation (21) pour transférer la première couche électriquement isolante (2a) et la première couche semi-conductrice monocristalline (2b) sur le substrat support (1), de sorte à former un premier substrat de type semi-conducteur sur isolant, ladite première étape de transfert de couche comprenant en outre un traitement thermique à une température suffisamment élevée pour lisser la première couche semi-conductrice monocristalline (2b) transférée sur le substrat support (1) jusqu'à une rugosité inférieure à 0,1 nm RMS,
- après ledit traitement thermique, une deuxième étape de transfert de couche comprenant une implantation d'espèces atomiques dans un second substrat donneur (30) pour y former une zone de fragilisation (31), un collage dudit second substrat donneur (30) sur la première couche semi-conductrice monocristalline (2b) du premier substrat de type semi-conducteur sur isolant, la seconde couche électriquement isolante (3a) étant à l'interface de collage entre le second substrat donneur (30) et la première couche semi-conductrice monocristalline (2b), et un détachement du second substrat donneur (30) le long de la zone de fragilisation (31) pour transférer la seconde couche électriquement isolante (3a) et la seconde couche semi-conductrice monocristalline (3b) sur la première couche semi-conductrice monocristalline du premier substrat de type semi-conducteur sur isolant.

2. Procédé selon la revendication 1, dans lequel les tranchées sont formées par gravure, la première couche électriquement isolante (2a) constituant une couche d'arrêt de ladite gravure.

3. Procédé selon l'une des revendications 1 ou 2 dans lequel l'épaisseur des première et seconde couches semi-conductrices monocristallines (2b, 3b) est comprise entre 25 et 40 nm.

4. Procédé selon l'une des revendications 1 à 3, dans lequel la première et la seconde couche semi-conductrice (2b, 3b) sont en silicium dopé de types opposés.

5. Procédé selon l'une des revendications 1 à 3, dans lequel la première et la seconde couche semi-conductrice (2b, 3b) sont en silicium présentant des orientations cristallines différentes.

6. Procédé selon l'une des revendications 1 à 3, dans lequel la première et la seconde couche semi-conductrice (2b, 3b) sont en des matériaux différents.

7. Dispositif selon l'une des revendications 1 à 3 et 6, dans lequel la couche semi-conductrice dans laquelle est formé le canal d'un transistor de type N est en silicium contraint.

8. Procédé selon l'une des revendications 1 à 3, 6 et 7, dans lequel la couche semi-conductrice dans laquelle est formé le canal d'un transistor de type P est en silicium-germanium.

9. Procédé selon l'une des revendications 1 à 8, dans lequel la première et/ou la seconde couche électriquement isolante (2a, 3a) est en oxyde de silicium (SiO₂).

10. Procédé selon l'une des revendications 1 à 8, dans lequel la première et la seconde couche électriquement isolante (2a, 3a) sont en des matériaux différents.

11. Procédé selon l'une des revendications 1 à 8 et 10, dans lequel la première couche (2a) électriquement isolante est en un matériau high k.

12. Procédé selon l'une des revendications 1 à 8, 10 et 11, dans lequel la seconde couche électriquement isolante (2b) est en un matériau low k.

13. Procédé selon l'une des revendications 1 à 12, comprenant la croissance par épitaxie d'une couche (1b) semi-conductrice sur le substrat support (1).

14. Procédé selon l'une des revendications 1 à 12, dans lequel le substrat support (1) comprend au moins une couche (1b) de silicium de type CZ « COP-free ».

15. Procédé selon l'une des revendications 1 à 14, dans laquelle le traitement thermique de lissage de la première couche semi-conductrice monocristalline (2b) est mis en oeuvre à une température comprise entre 1000 et 1200°C, pendant une durée comprise entre 10 et 120 minutes.

16. Procédé selon l'une des revendications 1 à 15, comprenant en outre un traitement thermique de finition de la seconde couche semi-conductrice monocristalline (3b) à une température comprise entre 1100 et 1250°C, pendant une durée inférieure à une minute.

## Patentansprüche

1. Verfahren zum Herstellen einer CFET-Vorrichtung, **dadurch gekennzeichnet, dass** es Folgendes umfasst:
- Bilden eines doppelten Halbleiter-auf-Isolator-Substrats, das nacheinander von seiner Basis bis zu seiner Oberfläche Folgendes umfasst: ein Trägersubstrat (1), eine erste elektrisch isolierende Schicht (2a), eine erste monokristalline Halbleiterschicht (2b), eine zweite elektrisch isolierende Schicht (3a), die eine Dicke zwischen 10 und 30 nm aufweist, und eine zweite monokristalline Halbleiterschicht (3b);
- Bilden von Gräben von der Oberfläche des Substrats bis zur ersten elektrisch isolierenden Schicht (2a), um mindestens eine Rippe (F) zu bilden,
- Bilden eines Kanals eines ersten Transistors in der ersten Halbleiterschicht (2b) und eines Kanals eines zweiten Transistors vom entgegengesetzten Typ zum ersten Transistor in der zweiten Halbleiterschicht (3b) in jeder Rippe (F),
wobei das Bilden des doppelten Halbleiter-auf-Isolator-Substrats Folgendes umfasst:
- einen ersten Schichtübertragungsschritt, der eine Implantation von Atomarten in ein erstes Donorsubstrat (20), um dort einen Schwächungsbereich (21) zu bilden, eine Kleben des ersten Donorsubstrats (20) auf das Trägersubstrat (1), wobei die erste elektrisch isolierende Schicht (2a) eine Klebeschnittstelle zwischen dem ersten Donorsubstrat (20) und dem Trägersubstrat (1) aufweist, und ein Ablösen des ersten Donorsubstrats (20) entlang des Schwächungsbereichs (21) umfasst, um die erste elektrisch isolierende Schicht (2a) und die erste monokristalline Halbleiterschicht (2b) auf das Trägersubstrat (1) zu übertragen, um so ein erstes Halbleiter-auf-Isolator-Substrat zu bilden, wobei der erste Schichtübertragungsschritt ferner eine Wärmebehandlung bei einer ausreichend hohen Temperatur umfasst, um die auf das Trägersubstrat (1) übertragene erste monokristalline Halbleiterschicht (2b) auf eine Rauheit von weniger als 0,1 nm RMS zu glätten,
- einen zweiten Schichtübertragungsschritt nach der Wärmebehandlung, der eine Implantation von Atomarten in ein zweites Donorsubstrat (30), um dort einen Schwächungsbereich (31) zu bilden, ein Kleben des zweiten Donorsubstrats (30) auf die erste monokristalline Halbleiterschicht (2b) des ersten Halbleiter-auf-Isolator-Substrats, wobei die zweite elektrisch isolierende Schicht (3a) eine Klebeschnittstelle zwischen dem zweiten Donorsubstrat (30) und der ersten monokristallinen Halbleiterschicht (2b) aufweist, und ein Ablösen des zweiten Donorsubstrats (30) entlang der Schwächungszone (31) umfasst, um die zweite elektrisch isolierende Schicht (3a) und die zweite monokristalline Halbleiterschicht (3b) auf die erste monokristalline Halbleiterschicht des ersten Halbleiter-auf-Isolator-Substrats zu übertragen.

2. Verfahren nach Anspruch 1, wobei die Gräben durch Ätzen gebildet werden, wobei die erste elektrisch isolierende Schicht (2a) eine Stoppschicht für das Ätzen bildet.

3. Verfahren nach einem der Ansprüche 1 oder 2, wobei die Dicke der ersten und der zweiten monokristallinen Halbleiterschicht (2b, 3b) zwischen 25 und 40 nm liegt.

4. Verfahren nach einem der Ansprüche 1 bis 3, wobei die erste und die zweite Halbleiterschicht (2b, 3b) aus dotiertem Silizium vom entgegengesetzten Typ bestehen.

5. Verfahren nach einem der Ansprüche 1 bis 3, wobei die erste und die zweite Halbleiterschicht (2b, 3b) aus Silizium bestehen und unterschiedliche Kristallorientierungen aufweisen.

6. Verfahren nach einem der Ansprüche 1 bis 3, wobei die erste und die zweite Halbleiterschicht (2b, 3b) aus unterschiedlichen Materialien bestehen.

7. Verfahren nach einem der Ansprüche 1 bis 3 und 6, wobei die Halbleiterschicht, in der der Kanal eines N-Typ-Transistors ausgebildet ist, aus verspanntem Silizium besteht.

8. Verfahren nach einem der Ansprüche 1 bis 3, 6 und 7, wobei die Halbleiterschicht, in der der Kanal eines P-Typ-Transistors ausgebildet ist, aus Silizium-Germanium besteht.

9. Verfahren nach einem der Ansprüche 1 bis 8, wobei die erste und/oder die zweite elektrisch isolierende Schicht (2a, 3a) aus Siliziumoxid (SiO₂) besteht.

10. Verfahren nach einem der Ansprüche 1 bis 8, wobei die erste und die zweite elektrisch isolierende Schicht (2a, 3a) aus unterschiedlichen Materialien bestehen.

11. Verfahren nach einem der Ansprüche 1 bis 8 und 10, wobei die erste elektrisch isolierende Schicht (2a) aus einem High-k-Material besteht.

12. Verfahren nach einem der Ansprüche 1 bis 8, 10 und 11, wobei die zweite elektrisch isolierende Schicht (2b) aus einem Low-k-Material besteht.

13. Verfahren nach einem der Ansprüche 1 bis 12, das das epitaktische Wachstum einer Halbleiterschicht (1b) auf dem Trägersubstrat (1) umfasst.

14. Verfahren nach einem der Ansprüche 1 bis 12, wobei das Trägersubstrat (1) mindestens eine "COPfreie" CZ-Siliziumschicht (1b) umfasst.

15. Verfahren nach einem der Ansprüche 1 bis 14, wobei die glättende Wärmebehandlung der ersten monokristallinen Halbleiterschicht (2b) bei einer Temperatur zwischen 1000 und 1200 °C während einer Zeitdauer zwischen 10 und 120 Minuten durchgeführt wird.

16. Verfahren nach einem der Ansprüche 1 bis 15, das ferner eine Wärmebehandlung zur Endbearbeitung der zweiten monokristallinen Halbleiterschicht (3b) bei einer Temperatur zwischen 1100 und 1250 °C während einer Zeitdauer von weniger als einer Minute umfasst.

## Claims

1. Process for manufacturing a CFET device, **characterized in that** it comprises:
- forming a double semiconductor-on-insulator substrate comprising in succession, from its base to its surface: a support substrate (1), a first electrically insulating layer (2a), a first monocrystalline semiconductor layer (2b), a second electrically insulating layer (3a) having a thickness of between 10 and 30 nm, and a second monocrystalline semiconductor layer (3b);
- forming trenches from the surface of said substrate to the first electrically insulating layer (2a) to form at least one fin (F),
- in each fin (F), forming a channel for a first transistor in the first semiconductor layer (2b) and a channel for a second transistor of the opposite type to the first transistor in the second semiconductor layer (3b),
wherein forming the double semiconductor-on-insulator substrate comprises:
- a first layer transfer step comprising implanting atomic species into a first donor substrate (20) to form an embrittlement zone (21) therein, bonding said first donor substrate (20) to the support substrate (1), with the first electrically insulating layer (2a) at the bonding interface between the first donor substrate (20) and the support substrate (1), and detaching the first donor substrate (20) along the embrittlement zone (21) to transfer the first electrically insulating layer (2a) and the first monocrystalline semiconductor layer (2b) onto the support substrate (1), thereby forming a first semiconductor-on-insulator substrate, said first layer transfer step further comprising a heat treatment at a sufficiently high temperature to smooth the first monocrystalline semiconductor layer (2b) transferred onto the support substrate (1) down to a roughness of less than 0.1 nm RMS,
- after said heat treatment, a second layer transfer step comprising implanting atomic species into a second donor substrate (30) to form an embrittlement zone (31) therein, bonding said second donor substrate (30) to the first monocrystalline semiconductor layer (2b) of the first semiconductor-on-insulator substrate, the second electrically insulating layer (3a) being at the bonding interface between the second donor substrate (30) and the first monocrystalline semiconductor layer (2b), and detaching the second donor substrate (30) along the embrittlement zone (31) to transfer the second electrically insulating layer (3a) and the second monocrystalline semiconductor layer (3b) onto the first monocrystalline semiconductor layer of the first semiconductor-on-insulator substrate.

2. Process according to claim 1, wherein the trenches are formed by etching, the first electrically insulating layer (2a) constituting a stop layer for said etching.

3. Process according to one of claims 1 or 2 wherein the thickness of the first and second monocrystalline semiconductor layers (2b, 3b) is between 25 and 40 nm.

4. Process according to one of claims 1 to 3, wherein the first and second semiconductor layers (2b, 3b) are made of doped silicon of opposite types.

5. Process according to one of claims 1 to 3, wherein the first and second semiconductor layers (2b, 3b) are made of silicon with different crystal orientations.

6. Process according to one of claims 1 to 3, wherein the first and second semiconductor layers (2b, 3b) are made of different materials.

7. Device according to one of claims 1 to 3 and 6, wherein the semiconductor layer in which the channel of an N-type transistor is formed is made of strained silicon.

8. Process according to one of claims 1 to 3, 6 and 7, wherein the semiconductor layer in which the channel of a P-type transistor is formed is made of silicon-germanium.

9. Process according to one of claims 1 to 8, wherein the first and/or second electrically insulating layer (2a, 3a) is made of silicon oxide (SiO₂).

10. Process according to one of claims 1 to 8, wherein the first and second electrically insulating layers (2a, 3a) are made of different materials.

11. Process according to one of claims 1 to 8 and 10, wherein the first electrically insulating layer (2a) is made of a high-k material.

12. Process according to one of claims 1 to 8, 10 and 11, wherein the second electrically insulating layer (2b) is made of a low-k material.

13. Process according to one of claims 1 to 12, comprising epitaxially growing a semiconductor layer (1b) on the support substrate (1).

14. Process according to one of claims 1 to 12, wherein the support substrate (1) comprises at least one layer (1b) of COP-free CZ silicon.

15. Process according to one of claims 1 to 14, wherein the heat treatment for smoothing the first monocrystalline semiconductor layer (2b) is carried out at a temperature of between 1000 and 1200°C, for a time of between 10 and 120 minutes.

16. Process according to one of claims 1 to 15, further comprising a finishing heat treatment of the second monocrystalline semiconductor layer (3b) at a temperature of between 1100 and 1250°C, for a time of less than one minute.
